(19)

**Europäisches Patentamt**

**European Patent Office**

**Office européen des brevets**

(11) **EP 4 521 598 A1**

(12) **EUROPEAN PATENT APPLICATION**

(43) Date of publication:
**12.03.2025 Bulletin 2025/11**

(21) Application number: **23195368.8**

(22) Date of filing: **05.09.2023**

(51) International Patent Classification (IPC):
*H02J 13/00* (2006.01) *G01R 19/25* (2006.01)

(52) Cooperative Patent Classification (CPC):
**H02J 13/00002; G01R 19/2513;** H02J 2203/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Karlsruher Institut für Technologie
76131 Karlsruhe (DE)**

(72) Inventors:
• **Courcelle, Maeva
76187 Karlsruhe (DE)**
• **De Carne, Giovanni
76227 Karlsruhe (DE)**
• **Tao, Qiucen
76185 Karlsruhe (DE)**

(54) **METHOD FOR DETERMINING LOAD PARAMETERS IN AN ELECTRICAL GRID**

(57)    A computer-implemented method (100) for determining at least one load parameter value of at least one load parameter defined by a load model of at least one electrical load comprising: Receiving from a data acquisition means at least one of the following synchronous data couples: Active power and voltage amplitude, Reactive power and voltage amplitude, Active power and frequency, or Reactive power and frequency; Generating continuously a first data set and a second data set from the data couples collected over a time window, wherein the first and second data sets comprise at least two samples, and the first data set represents: Active power samples, or Reactive power samples; Calculating continuously a respective variation of the first and the second data sets; Comparing (102) continuously the variation of the first data set with a discontinuity limit, wherein a discontinuity is given when the variation of the first data set exceeds the discontinuity limit; Comparing (101) continuously the variation of the second data set with a disturbance variation detection limit, wherein a disturbance is given when the variation of the second data set exceeds the disturbance variation detection limit, and wherein the disturbance ends when the variation of the second data set falls below the disturbance variation detection limit; Calculating (103) the at least one load parameter value of the load parameter by means of a numerical method.

Fig. 1

**Description**

The technical field of this invention addresses the requirement of calculating a highly accurate load parameter, during small disturbances compared to conventional solutions. Furthermore, the identification of the load parameter is provided in real-time.

Prior art for said invention is a method as disclosed in document [1], wherein this method provides a real-time load sensitivity identification based on a disturbance event. This method is also disclosed in [2], wherein the synchronization of the calculation window with the disturbance window occurs through a communication with an actuator. Furthermore, to calculate load parameters using a disturbance event, as disclosed in documents [3, 4], in contrary, a comparison of voltage values is disclosed to target the disturbance window. Moreover, document [5] discloses a further method that compares voltage values with a voltage threshold and checks the common direction of variations of voltage and power, and thus uses the obtained disturbance window for the calculation.

However, previously mentioned methods are not suitable for the detection of smaller disturbances, but the use of small disturbances between 0,01% to 5% of the nominal voltage for the load parameter identification is more appropriate for an electrical grid (= grid), and can also be created by a smart device. Former solutions using bigger disturbances are limited by making use of a threshold or a minimum variation percentage for disturbance detection. Moreover, additional synchronization is required in the conventional cases of a non-integrated system.

The objective technical problem herein is to provide a method for determining load parameters during a disturbance, namely, small or big variations between 0,01% to 10% of the nominal voltage (or frequency), wherein the disturbance detection operates autonomously.

This aforementioned objective technical problem is solved by the method disclosed herein according to the features of the first independent claim 1. Subsidiary or dependent claims relating thereto reflect advantageous designs or embodiments. Advantageous further embodiments, which can be realized individually or in any combination, are shown in the dependent claims.

In the following, the terms "having", "comprising" or "including" or any grammatical variations thereof are used in a non-exclusive manner. Accordingly, these terms may refer both to situations in which, in addition to the features introduced by these terms, no further features are present, or to situations in which one or more further features are present. For example, the expression "A has B", "A includes B" or "A includes B" may refer both to the situation in which, apart from B, no other element is present in A (i.e. to a situation in which A consists exclusively of B), and to the situation in which, in addition to B, one or more other elements are present in A, for example, element C, elements C and D or even other elements.

Furthermore, it is noted that the terms "at least one" and "one or more" as well as grammatical variations of these terms, when used in connection with one or more elements or features and intended to express that the element or feature may be provided once or more than once, are generally used only once, for example, when the feature or element is first introduced. When the feature or element is subsequently mentioned again, the corresponding term "at least one" or "one or more" is generally no longer used, without limitation of the possibility that the feature or element may be provided singly or more than once.

Further, the terms "preferably", "in particular", "for example (e.g.)" or similar terms are used hereinafter in connection with optional features, without limiting alternative embodiments thereby. Thus, features introduced by these terms are optional features, and it is not intended to limit the scope of protection of the claims, and in particular the independent claims, by these features. Thus, as will be recognized by those skilled in the art, the invention may be carried out using other embodiments. Similarly, features which are introduced by "in one embodiment" or by "in a further embodiment" are understood as optional features without intending to limit alternative embodiments or the scope of protection of the independent claims. Furthermore, all possibilities of combining features introduced thereby with other features, whether optional or non-optional, shall remain unaffected by these introductory expressions.

General description and embodiments

As used herein, the term "load parameter", defined in [8] refers to:

- the exponent Kp in the exponential load model, wherein:

    o the relation between power and voltage is given by

$$P = P_0 \left(\frac{V}{V_0}\right)^{K_p} \qquad\qquad (1)$$

or

o the relation between power and frequency is given by

$$P = P_0 \left(\frac{f}{f_0}\right)^{K_p}. \qquad (2)$$

- The factors Kz, Ki, or Kp in the ZIP load model are derived by:

$$P = P_0 \left(K_Z \left(\frac{V}{V_0}\right)^2 + K_I \left(\frac{V}{V_0}\right)^1 + K_P\right) \qquad (3)$$

As used herein, the term "load parameter values" refers to the calculated values of the load parameter.

As used herein, the term "load model" refers to a mathematical representation of an electrical load that is used to simulate its behavior under different operation conditions (static load models (exponential load model, ZIP load model), dynamic load models (induction motor (IM), exponential recovery load model), composite load models (ZIP+IM, complex load model), or artificial neural network-based models (ANN)), wherein all aforementioned load models are introduced in [7].

As used herein, the term "electrical load" refers to any device or system that consumes electrical power, such as lighting fixtures, appliances, motors, and electronic devices.

As used herein, the term "electrical grid" refers to a network of power generation, transmission, and distribution systems that deliver electricity from power plants to end-users.

As used herein, the term "variation" refers to a change in magnitude.

As used herein, the term "disturbance" refers to a change of voltage characteristics (e.g. voltage amplitude or frequency).

As used herein, the term "discontinuity limit" refers to a threshold value beyond which a sudden change or disruption in the power behavior, such as a load change, is observed.

As used herein, the term "disturbance variation detection limit" refers to a threshold value that is used to detect disturbances or changes in the voltage behavior, such as a voltage change through a tap-changer, or a voltage variation created by a state transformer.

As used herein, the term "numerical method" refers to a mathematical algorithm or technique used to solve the system of equations enabling to calculate a load parameter value of a load model, such as linearization, Least-Square-based algorithms, or optimization algorithms.

As used herein, the term "pre-disturbance duration" refers to the time window taken before the disturbance window, wherein the pre-disturbance duration should be bigger than one disturbance period (if the disturbance is a periodical signal), of bigger than the disturbance itself.

In a first embodiment a computer-implemented method for determining at least one load parameter value of at least one load parameter defined by a load model of at least one electrical load, which is coupled to an electrical grid, comprising:

- Receiving from a data acquisition means at least one of the following synchronous data couples, which have the same sampling rate: Active power and voltage amplitude, Reactive power and voltage amplitude, Active power and frequency, or Reactive power and frequency;

- Generating continuously a first data set and a second data set from the data couples collected over a predetermined time window, wherein the first and second data sets comprise at least two samples, and the first data set represents: Active power samples, or Reactive power samples, and the second data set represents: Voltage amplitude samples, or Frequency samples, and wherein the length of the predetermined time window depends on the sampling rate of the data couple;

- Calculating continuously a respective variation of the first and the second data sets;

- Comparing continuously the variation of the first data set with a predetermined discontinuity limit, wherein a discontinuity is given when the variation of the first data set exceeds the discontinuity limit;

- Comparing continuously the variation of the second data set with a predetermined disturbance variation detection limit, wherein a disturbance is given when the variation of the second data set exceeds the disturbance variation detection limit, and wherein the disturbance ends when the variation of the second data set falls below the disturbance variation detection limit;

- Calculating the at least one load parameter value of the load parameter by means of a numerical method, wherein the calculation starts when the disturbance is given, and the calculation interrupts when the disturbance ends, or when the discontinuity is given, wherein a disturbance time window is set by the duration between the start of the first calculation and its interruption;

- Generating, when the calculation of the at least one load parameter value interrupts, a third data set and a fourth data set over the disturbance time window, wherein the third data set comprises at least two samples, and the third data set represents: Active power samples during the disturbance time window, or Reactive power samples during the disturbance time window, and the fourth data set represents: the at least one load parameter value calculated during the disturbance time window;

- Generating a fifth data set over a pre-disturbance time window, wherein a pre-disturbance time window is set by a predetermined pre-disturbance duration, ending with the start of the first calculation of the at least one load parameter value, wherein the fifth data set represents: Active power samples during the pre-disturbance time window, or Reactive power samples during the pre-disturbance time window;

- Calculating a respective variation of the third and the fifth data sets;

- Comparing the variation of the third data set with the variation of the fifth data set, wherein a trust case is given when the variation of the third data set exceeds the variation of the fifth data set;

- Calculating an average load parameter given by the mean value of the fourth data set, if the trust case is given.

In a further embodiment a sensor assembly comprises at least a first sensor and a second sensor which are set up in such a way that the first sensor measures a voltage and the second sensor measures a current of at least one electrical load in an electrical grid, wherein the sensor assembly is coupled to the electrical load and comprises at least one output means.

In a further embodiment a data acquisition means is coupled to the output means of the sensor assembly according to the previous embodiment and is set up in such a way that it calculates: from the voltage and current: a voltage amplitude, a current amplitude, a phase lag between voltage and current, and optional, a frequency; and from the voltage amplitude, the current amplitude and the phase lag: an active power, or a reactive power; wherein the data acquisition means comprises an output means, which is set up in such a way that it transfers at least one of the following data couples: Active power and voltage amplitude, Reactive power and voltage amplitude, Active power and frequency, or Reactive power and frequency.

In a further embodiment a data acquisition means according to the previous embodiment is further set up in such a way that if the data couples have different sampling rates, it resamples the data couples so that they are synchronized.

In further embodiment a computer program comprising instructions which, when the program is executed by a computer, causes the computer to carry out the method the first embodiment.

In a further embodiment a computer-readable medium having stored thereon the computer program according to the previous embodiment.

The claimed solution herein covers different technical fields like load modeling, power electronics, transformers, tap-changers, and real-time identification. Previously, a method for operating the electrical grid by means of load sensitivity information has been proposed in [1]. The method allows to shape the power consumption of the grid by means of controlled voltage and frequency changes. It is run in real-time and values are continuously updated. This document focuses on the control of the grid and not on sensitivity estimation. The sensitivity estimation method, instead, has been published in publication [6]. The On-Line Load Sensitivity Identification (OLLI) is an evaluation method of the exponential load model parameters with frequency dependency. The identification method approximates the exponential load model. It is based on a grid disturbance (e.g. voltage and/or frequency). The work proposes only the general methodology, without including any implementation details. Improvements of the method have been proposed in reference [2], where the real-time load sensitivity identification disclosed in [6], has been applied to a Smart Transformer. Experimental validation verifies the feasibility of that approach. The method discloses a bad data rejection based on calculated sensitivity values.

The claimed solution herein allows a more accurate estimation of the sensitivities, including pre- and post-processing methodologies. Like most of the measurement-based methods as disclosed in [7], the online identification as disclosed in [6] also uses a disturbance to calculate the load sensitivities, with the big advantage that it enables to calculate them in real-time, namely during the measurements. However, in that case, it is shown to trigger (cf. [2]) the disturbance using a controllable actuator (like a Smart Transformer), and to calculate the power dependencies to voltage and frequency, as often as wished. In this way, the method takes the daily load variability, and load component state into account, without additional grid information. Actually, loads are constantly varying in the grid, so the load parameters need to be updated before executing a control.

The electrical grid integrates more and more renewable energy sources and thus power-electronic-based devices. As a consequence, the electricity supply becomes less predictable, and more real-time controllers are needed to make the converters meet the grid codes. In this regard, it is vital to have updated and accurate data from the field. This becomes important if we consider acting on the demand consumption, and in particular, acting on the voltage and frequency-dependent loads. These loads vary the load consumption if the voltage or frequency at their point of coupling varies. However, no accurate control can be achieved, without an accurate estimation of these loads' power sensitivities on voltage or frequency. The invention enables the identification of these sensitivities with high accuracy, rejecting non-wanted disturbances, and automatically adapting the parameters identification to the load's characteristics (mostly the state (power consumption)).

Actually, these similar state-of-the-art solutions do not fully solve the problem because:

o The disclosure in [1], with respect to this claimed solution herein, needs an on-purpose voltage and/or frequency disturbance (it is not able to detect external disturbances (e.g. tap change of a transformer)), does not consider non-wanted disturbance rejection (noise, state change), does not have pre- and post-filtering capability, and it does not include an approach to automatically update the sensitivity. In addition, the On-Line Load Sensitivity Identification method in [1] cannot be applied in real conditions without synchronization with the disturbance actuator. It is related only to the control of the grid, and not to the load sensitivity estimation.

∘ The disclosure in [2] is only the general methodology, without any implementation details. There is no mention of pre- or post-processing capability, noise and disturbance rejection, or automatic update of the load sensitivities.

∘ The disclosure in [6] is an experimental validation of the method of [2], but it does not offer any new methodology to the current state of the art.

On the contrary, connected at the load's point of coupling, the claimed solution herein is able to calculate the aggregated sensitivity parameters of the connected loads, wherein the load sensitivity identification is done during a disturbance that the invention is able to detect without external communication.

In more detail, the claimed solution herein first detects the disturbance on voltage or frequency signals, without the need of external synchronization. Then, it calculates the load sensitivity values during the voltage or frequency variations and provides a quantification of the estimation accuracy. Finally, it provides a filtered value directly after the end of the disturbance, which enables prompt sensitivity identification.

To do so, the claimed solution herein must have access at least to the following grid measurement couples: voltage and active power, voltage and reactive power, frequency and active power, or frequency and reactive power, depending on the load sensitivity that should be calculated. Also, the claimed solution herein must be able to perform several tasks in parallel (for instance, data acquisition and load parameters calculation).

Compared to the state-of-the-art, the claimed solution herein provides:

- Disturbance detection: the method is able to detect frequency and voltage disturbances, and to understand if they are usable for the load sensitivity identification by differentiating them from non-wanted disturbances.

- Sensitivity update: the method is able to identify the type of power variation, like a state change (due to load variation), a disturbance reflection (due to power sensitivity to voltage or frequency disturbance), or noise (measurements or grid noise).

- Power measurement-based error detection: the method evaluates the noise of the power signal to decide if the calculated sensitivity has been calculated in an accurate way.

- Disturbance coordination: In an optional embodiment the tool is capable to interact with the controller that applies voltage or frequency disturbance, or at least with the user itself. Indeed, the tool should know the shape, size, and frequency of the expected disturbance applied to the grid by the actuator.

By doing so, the claimed solution herein achieves advantages, such as:

- No need for synchronization: The proposed invention is able to identify the presence of the on-purpose disturbance without the need for a synchronization signal between the identification tool and the disturbance actuator. In this way, the identification approach can be decentralized and no communication infrastructure is needed.

- Distributed load sensitivity identification: in a further embodiment the method can work independently from the actuator, which triggers the disturbance. One central controller can decide the set points of all available actuators in the grid. Since the load sensitivity identification can be decentralized, the sensitivity identification can be triggered as often as wished, and values could be sent back to the central controller. The setup enables finer control of the electrical network and is suitable despite the high integration of distributed generation.

- Automatic detection of needed update: in a further embodiment it can trigger the update without the request of the central controller, since the load sensitivity identification method is autonomous. If the load set has changed, the new state is detected through the power measurement. In case of a grid state change, the load sensitivity value may change and need to be updated.

The claimed solution herein has already been experimentally tested at the Karlsruhe Institute of Technology (KIT), where tests of the algorithm with off-line measurements have been performed. The results are the following:

- The method is able to detect the disturbance and to calculate the load sensitivity in the aforementioned cases, both for voltage and frequency.

- The method is robust to external disturbance and noise, and it is able to reject bad measurement data.

- The calculated sensitivity enables to reconstruct the power signal variations using the exponential load model. The reconstructed power waveform matches the initial measurement.

Brief description of the figures

Further details and features of the present invention result from the following description of a preferred embodiment, in particular in connection with the dependent claims. Here, the respective features can be realized alone or in combination with each other. The invention is not limited to the embodiment examples or forms.

The examples or forms of embodiment are shown schematically in the following figures. Here, identical reference numerals in the figures designate identical or functionally identical elements or elements corresponding to one another with respect to their functions.

For illustrative purposes and without limiting effect, further features and advantages of the invention result from the description of the accompanying drawings. Therein shows:

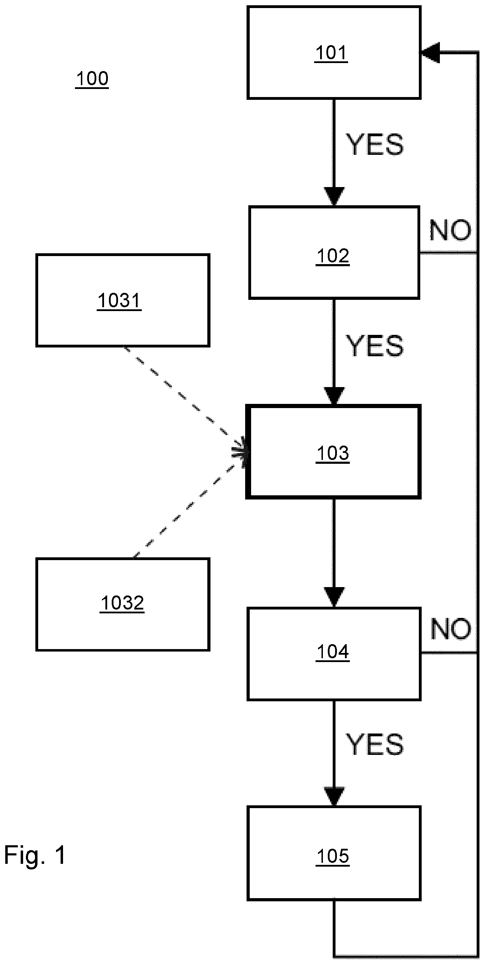

Fig. 1  a flow chart of the load sensitivity identification process with disturbance detection according to claim 1;

Fig. 2  a schematic graph for disturbance detection using an estimator; and

Fig. 3  a schematic sketch of an application of a method according to claim 1.Figure 1 shows a flow chart 100 of the load sensitivity identification process with disturbance detection according to claim 1.

In a first step 101, which corresponds to the disturbance detection, wherein the variation of the second data set is compared with the disturbance variation detection limit. If the variation of the second data set exceeds the disturbance variation detection limit, the process continues, otherwise, the variation of the second data step keep to be compared with the disturbance variation detection limit.

The variation of the second data set is represented by the variable $\hat{E}_{dist}$ and is described by the equation (4):

$$\hat{E}_{dist} = \frac{\hat{\sigma}_N}{V_0 \cdot a_{dist/\%}} \qquad (4)$$

- where $\hat{\sigma}_N$ is the calculated standard deviation of the signal over $N$ points, $V_0$ is the rated value of the disturbance quantity, and $a_{dist/\%}$ is the percentage of the amplitude variation of the disturbance to the rated value of the disturbance quantity.

- wherein, the rated value of the disturbance quantity corresponds to the average value of the quantity before the disturbance, where the disturbance quantity describes the physical quantity of the second data set, being either the voltage or the frequency.

- wherein, the variable $N$ influences the standard deviation $\hat{\sigma}_N$.

  o wherein, $N$ is chosen so that the disturbance period $T_{dist}$, which is equal to 1 in the case of non-periodic disturbance, and the measurement sampling time $t_s$ do not impact the standard deviation $\hat{\sigma}_N$ and consequently the variation of the second data set $\hat{E}_{dist}$ anymore.
  ∘ wherein, $\alpha$ represents the ratio of the size of the predetermined time window to the number of measurement samples in one period of the disturbance and is defined by equation (5):

$$\alpha = \frac{N}{N_{pt/period}} \qquad (5)$$

where $N$ represents the size of the predetermined time window, and $N_{pt/period}$ represents the number of measurement samples in one period of the disturbance.

  ▪ wherein, $N_{pt/period}$ is defined by equation (6) :

$$N_{pt/period} = \frac{T_{dist}}{t_s} \qquad (6)$$

  ▪ wherein, $\alpha$ can be chosen in the range from 0.8 to 1.0, where the impact on the detection accuracy will be small.

- wherein, the detection variation detection limit is set between 0.2 and 0.5, namely, when the estimator $\hat{E}_{dist}$ is bigger than the limit, a disturbance is given.

In a second step 102, the power variation is analyzed, wherein the variation of the first data set is compared with the discontinuity limit. If a discontinuity is detected, the process stops and go back to 101, otherwise, it continues. Similar to 101, the variation of the first data set is described by the variable $\hat{E}_{power}$ and is defined by equation (7) :

$$\hat{E}_{power} = \frac{\hat{\sigma}_N}{P_{max} \cdot a_{dist/\%} \cdot K_{P0}} \qquad (7)$$

where $\hat{\sigma}_N$ is the standard deviation of the power quantity calculated over $N$ values defined in 101, $a_{dist/\%}$ is the disturbance amplitude variation in percent of the rated power value, $P_{max}$ is the maximum power measured in the last window, where the window size depends on the system dynamic, and $K_{P0}$ is the previously calculated load sensitivity.

- wherein, the discontinuity limit is tuned depending on the system size (number of loads and nominal power) and depending on the disturbance magnitude.

- wherein, for example the previously calculated load sensitivity is initialized with $K_{P0} = 10$.

In a third step 103, the load parameter values are calculated. When the disturbance ends, the process continues.

- wherein, the load parameter identification is influenced by the chosen load model 1031 and by the chosen load parameter identification method 1032.

In a fourth step 104, the variation of the third data set is compared to the variation of the fifth data set. If a trust case is given, the process continues, otherwise, it goes back to 101.
In a fifth step 105, the average load parameter is calculated for the disturbance time window.

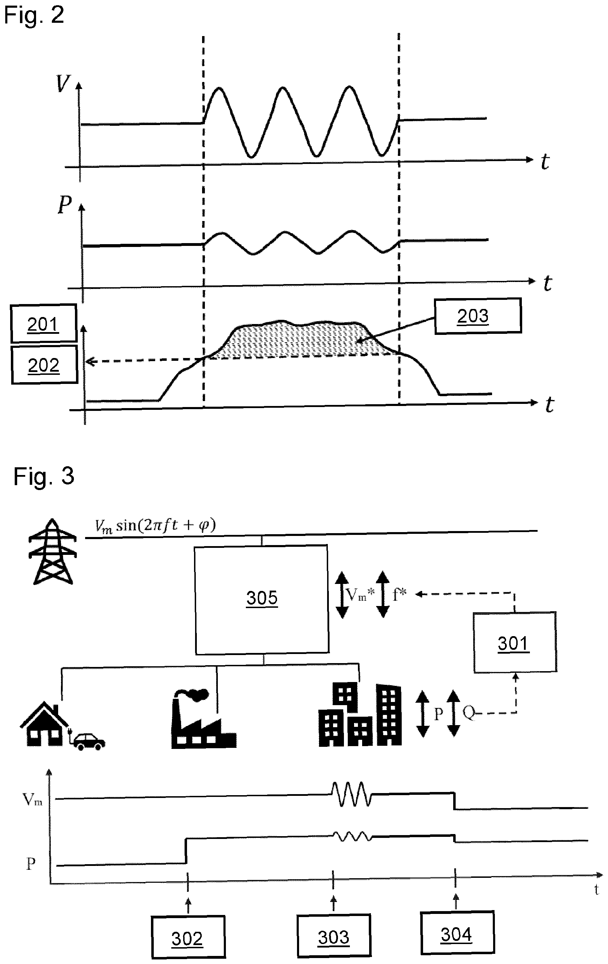

Figure 2 shows the disturbance detection, using the variation estimator.
The first graph shows the quantity of the second data set over time, where a disturbance is given.
The second graph shows the quantity of the first data set over time, where the disturbance of quantity of the second data set impacts the quantity of the first data set.

The third graph shows the variation of the quantity of second data set over time (e.g. $\hat{E}_{dist}$), described in equation (4). $\hat{E}_{dist}$ is compared to the predetermined disturbance variation detection limit (e.g. $\sigma_{lim}$) that is set between 0.2 and 0.5. A disturbance is given when the variation of the second data set exceeds the disturbance variation detection limit (e.g. $\hat{E}_{dist} > \sigma_{lim}$).

Figure 300 shows one use of the online load parameter identification method according to claim 1.

- wherein, an AC grid is represented, where the voltage wave is defined by the equation:

$$v(t) = V_m \cdot \sin(2\pi f t) \qquad (8)$$

where the grid voltage is characterized by its voltage amplitude $V_m$ and its frequency $f$.
- wherein, the grid is interfaced with the different loads through a transformer or a power electronic converter (305). These devices are able to change the setpoints, namely the characteristics of the grid at the load side (e.g. $V_m^*$ or $f^*$}.

In a first step 302, a state change is detected and a load parameter identification for a finer control is required.

In a second step 303, the disturbance is created by the power electronic device 305. A load parameter is calculating during the given disturbance, detected by the claimed solution (301),

- wherein, the claimed solution measures voltage and power variations, and calculate the corresponding load parameters;
- wherein the load sensitivity is communicated to the main grid interface 305, and is used for a finer control.

In a third step 304, a new setpoint (e.g. $V_m^*$ or $f^*$) is generated by the power electronic device 305.

Bibliography

[1]EP 3 591 820 B1: "METHOD FOR CONTROLLING A GRID-FORMING CONVERTER, COMPUTER PROGRAM AND GRID-FORMING CONVERTER"

[2] G. De Carne, S. Bruno, M. Liserre and M. La Scala, "Distributed Online Load Sensitivity Identification by Smart Transformer and Industrial Metering," in IEEE Transactions on Industry Applications, vol. 55, no. 6, pp. 7328-7337, Nov.-Dec. 2019, doi: https://doi.org/10.1109/TIA.2019.2918053.

[3]M. Leinakse, P. Tani and J. Kilter, "Impact of Distributed Generation on Estimation of Exponential Load Models," 2019 IEEE Power & Energy Society General Meeting (PESGM), Atlanta, GA, USA, 2019, pp. 1-5, doi: https://doi.org/10.1109/PESGM40551.2019.8974014.

[4] Y. Zhu and J. V. Milanović, "Automatic Identification of Power System Load Models Based on Field Measurements," in IEEE Transactions on Power Systems, vol. 33, no. 3, pp. 3162-3171, May 2018, doi: https://doi.org/10.1109/TPWRS.2017.2763752.

[5] C. A. Baone, S. Veda, Y. Pan, W. Premerlani, J. Dai and A. Johnson, "Measurement based static load model identification," 2015 IEEE Power & Energy Society General Meeting, Denver, CO, USA, 2015, pp. 1-5, doi: https://doi.org/10.1109/PESGM.2015.7285681

[6] G. De Carne, M. Liserre and C. Vournas, "On-Line Load Sensitivity Identification in LV Distribution Grids," in IEEE Transactions on Power Systems, vol. 32, no. 2, pp. 1570-1571, March 2017, doi: 10.1109/TPWRS.2016.2581979.

[7]A. Arif, Z. Wang, J. Wang, B. Mather, H. Bashualdo and D. Zhao, "Load Modeling-A Review," in IEEE Transactions on Smart Grid, vol. 9, no. 6, pp. 5986-5999, Nov. 2018, doi: 10.1109/TSG.2017.2700436.

[8] P. Kundur, N.J. Balu, "Power System Stability and Control," in McGraw-Hill, pp. 273-274, 1994.

EP 4 521 598 A1

List of reference signs

| | |
|---|---|
| 100 | embodiment of a method according to the respective corresponding claims 1. |
| 101 | Disturbance given? |
| 102 | No discontinuity given? |
| 103 | Load parameter identification |
| 1031 | Load model |
| 1032 | Load parameter identification method |
| 104 | Trust case given? |
| 105 | Average of the load parameter values over the disturbance time window |
| 201 | $\hat{E}_{dist}$: Disturbance variation |
| 202 | $\sigma_{lim}$: Disturbance variation detection limit |
| 203 | $\hat{E}_{dist} > \sigma_{lim}$: The disturbance variation exceeds the disturbance variation limit |
| 301 | Load parameter identification |
| 302 | New control needed |
| 303 | Disturbance |
| 304 | New setpoint |
| 305 | Power electronic device |

**Claims**

**1.** A computer-implemented method for determining at least one load parameter value (100) of at least one load parameter defined by a load model (1031) of at least one electrical load, which is coupled to an electrical grid (301), comprising:

   1.1. Receiving from a data acquisition means at least one of the following synchronous data couples, which have the same sampling rate:

      1.1.1. Active power and voltage amplitude,
      1.1.2. Reactive power and voltage amplitude,
      1.1.3. Active power and frequency, or
      1.1.4. Reactive power and frequency;

   1.2. Generating continuously a first data set and a second data set from the data couples collected over a predetermined time window,

      1.2.1. wherein the first and second data sets comprise at least two samples, and
      1.2.2. the first data set represents:

         1.2.2.1. Active power samples,
         or
         1.2.2.2. Reactive power samples,

      and the second data set represents:

         1.2.2.3. Voltage amplitude samples,
         or
         1.2.2.4. Frequency samples,

      and
      1.2.3. wherein the length of the predetermined time window depends on the sampling rate of the data couple;

   1.3. Calculating continuously a respective variation of the first (201) and the second data sets;
   1.4. Comparing (102) continuously the variation of the first data set with a predetermined discontinuity limit,
   1.4.1. wherein a discontinuity is given when the variation of the first data set exceeds the discontinuity limit;
   1.5. Comparing (101) continuously the variation of the second data set with a predetermined disturbance variation

9

detection limit (202),

1.5.1. wherein a disturbance is given when the variation of the second data set exceeds (203) the disturbance variation detection limit, and
1.5.2. wherein the disturbance ends when the variation of the second data set falls below the disturbance variation detection limit;

1.6. Calculating (103) the at least one load parameter value of the load parameter by means of a numerical method (1032),

1.6.1. wherein the calculation starts when the disturbance is given, and
1.6.2. the calculation interrupts

1.6.2.1. when the disturbance ends, or
1.6.2.2. when the discontinuity is given,

1.6.3. wherein a disturbance time window is set by the duration between the start of the first calculation and its interruption;

1.7. Generating, when the calculation of the at least one load parameter value interrupts, a third data set and a fourth data set over the disturbance time window,

1.7.1. wherein the third data set comprises at least two samples, and
1.7.2. the third data set represents:

1.7.2.1. Active power samples during the disturbance time window, or
1.7.2.2. Reactive power samples during the disturbance time window, and the fourth data set represents:
1.7.2.3. the at least one load parameter value calculated during the disturbance time window;

1.8. Generating a fifth data set over a pre-disturbance time window,

1.8.1. wherein a pre-disturbance time window is set by a predetermined pre-disturbance duration, ending with the start of the first calculation of the at least one load parameter value,
1.8.2. wherein the fifth data set represents:

1.8.2.1. Active power samples during the pre-disturbance time window, or
1.8.2.2. Reactive power samples during the pre-disturbance time window;

1.9. Calculating a respective variation of the third and the fifth data sets;
1.10. Comparing (104) the variation of the third data set with the variation of the fifth data set,
1.10.1. wherein a trust case is given when the variation of the third data set exceeds the variation of the fifth data set;
1.11. Calculating (105) an average load parameter given by the mean value of the fourth data set,
1.11.1. if the trust case is given.

2. A sensor assembly comprises at least a first sensor and a second sensor which are set up in such a way that the first sensor measures a voltage and the second sensor measures a current of at least one electrical load in an electrical grid, wherein the sensor assembly is coupled to the electrical load and comprises at least one output means.

3. A data acquisition means is coupled to the output means of the sensor assembly according to claim 2 and is set up in such a way that it calculates:

3.1. from the voltage and current:

3.1.1. a voltage amplitude,
3.1.2. a current amplitude,
3.1.3. a phase lag between voltage and current, and
3.1.4. optional, a frequency;
and
3.1.5. from the voltage amplitude, the current amplitude, and the phase lag:

3.1.5.1. an active power, or
3.1.5.2. a reactive power;

3.1.6. wherein the data acquisition means comprises an output means, which is set up in such a way that it transfers at least one of the following data couples:

3.1.6.1. Active power and voltage amplitude,
3.1.6.2. Reactive power and voltage amplitude,
3.1.6.3. Active power and frequency, or
3.1.6.4. Reactive power and frequency.

4. A data acquisition means according to claim 3 is further set up in such a way that if the data couples have different sampling rates, it resamples the data couples so that they are synchronized.

5. A computer program comprising instructions which, when the program is executed by a computer, causes the computer to carry out the method of claim 1.

6. A computer-readable medium having stored thereon the computer program of claim 5.

100

101

YES

NO

102

1031

YES

103

1032

104

NO

YES

105

Fig. 1

## Fig. 2

## Fig. 3

$$V_m \sin(2\pi f t + \varphi)$$

Europäisches
Patentamt

European
Patent Office

Office européen
des brevets

# EUROPEAN SEARCH REPORT

Application Number

EP 23 19 5368

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2011/126732 A1 (SCHWEITZER ENGINEERING LAB INC [US] ET AL.) 13 October 2011 (2011-10-13) * paragraphs [0001], [0031] * * claim 1 * | 1-6 | INV. H02J13/00 G01R19/25 |
| A | CN 101 924 393 B (XU WENYUAN) 3 April 2013 (2013-04-03) * the whole document * | 1-6 | |
| X | BENTARZI HAMID ET AL: "PMU based SCADA enhancement in smart power grid", 2018 IEEE 12TH INTERNATIONAL CONFERENCE ON COMPATIBILITY, POWER ELECTRONICS AND POWER ENGINEERING (CPE-POWERENG 2018), IEEE, 10 April 2018 (2018-04-10), pages 1-6, XP033353619, DOI: 10.1109/CPE.2018.8372580 [retrieved on 2018-06-04] | 2 | |
| A | * page 3 * * page 5 * | 1,3-6 | TECHNICAL FIELDS SEARCHED (IPC) H02J G01R |

The present search report has been drawn up for all claims

| Place of search | Date of completion of the search | Examiner |
|---|---|---|
| Munich | 7 March 2024 | Zettler, Karl-Rudolf |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    ........................................................................
& : member of the same patent family, corresponding
    document

EPO FORM 1503 03.82 (P04C01)

**EP 4 521 598 A1**

## ANNEX TO THE EUROPEAN SEARCH REPORT
## ON EUROPEAN PATENT APPLICATION NO.

EP 23 19 5368

This annex lists the patent family members relating to the patent documents cited in  the above-mentioned European search report.
The members are as contained in the European Patent Office EDP file on
The European Patent Office is in no way liable for these particulars which are merely given for the purpose of information.

07-03-2024

| Patent document cited in search report | | Publication date | Patent family member(s) | | Publication date |
|---|---|---|---|---|---|
| WO 2011126732 | A1 | 13-10-2011 | AU | 2011238726 A1 | 01-11-2012 |
| | | | BR | 112012025984 A2 | 24-09-2019 |
| | | | CA | 2795718 A1 | 13-10-2011 |
| | | | NZ | 602837 A | 26-09-2014 |
| | | | US | 2011251732 A1 | 13-10-2011 |
| | | | WO | 2011126732 A1 | 13-10-2011 |
| CN 101924393 | B | 03-04-2013 | NONE | | |

EPO FORM P0459

**REFERENCES CITED IN THE DESCRIPTION**

**Patent documents cited in the description**

- EP 3591820 B1

**Non-patent literature cited in the description**

- **G. DE CARNE** ; **S. BRUNO** ; **M. LISERRE** ; **M. LA SCALA**. Distributed Online Load Sensitivity Identification by Smart Transformer and Industrial Metering. *IEEE Transactions on Industry Applications*, November 2019, vol. 55 (6), 7328-7337, https://doi.org/10.1109/TIA.2019.2918053
- **M. LEINAKSE** ; **P. TANI** ; **J. KILTER**. Impact of Distributed Generation on Estimation of Exponential Load Models. *2019 IEEE Power & Energy Society General Meeting (PESGM), Atlanta, GA, USA*, 2019, 1-5, https://doi.org/10.1109/PESGM40551.2019.8974014

- **C. A. BAONE** ; **S. VEDA** ; **Y. PAN** ; **W. PREMERLANI** ; **J. DAI** ; **A. JOHNSON**. Measurement based static load model identification. *2015 IEEE Power & Energy Society General Meeting, Denver, CO, USA*, 2015, 1-5, https://doi.org/10.1109/PESGM.2015.7285681
- **G. DE CARNE** ; **M. LISERRE** ; **C. VOURNAS**. On-Line Load Sensitivity Identification in LV Distribution Grids. *IEEE Transactions on Power Systems*, March 2017, vol. 32 (2), 1570-1571
- **A. ARIF** ; **Z. WANG** ; **J. WANG** ; **B. MATHER** ; **H. BASHUALDO** ; **D. ZHAO**. Load Modeling-A Review. *IEEE Transactions on Smart Grid*, November 2018, vol. 9 (6), 5986-5999
- **P. KUNDUR** ; **N.J. BALU**. Power System Stability and Control. McGraw-Hill, 1994, 273-274